# EUROPEAN PATENT APPLICATION

(11) **EP 2 073 473 A1**
(43) Date of publication of application: **24.06.2009**
(21) Application number: 07150377.5
(22) Date of filing: 21.12.2007
(51) Int. Cl.: H04L 27/26, H03G 3/20

(54) **A Method and Device for Automatic Gain Control**

(71) Applicant: TELEFONAKTIEBOLAGET LM ERICSSON (publ), 164 83 Stockholm (SE)
(72) Inventor: Andgart, Niklas, 247 33, Södra Sandby (SE); Bernhardsson, Bo, 224 75, Lund (SE); Nordström, Fredrik, 223 53, Lund (SE); Wilhelmsson, Leif, 240 10, Dalby (SE)
(74) Representative: Andersson, Björn E.

(57) **Abstract**

A method and apparatus for adjusting the gain of an amplifier (202) in a communication receiver comprising: estimating the power of a time domain signal (307); estimating the power distribution on one or more sub-carriers of a frequency domain signal (309) transformed from the time domain signal; and generating a gain control signal for the amplifier based on the estimated power of the time domain signal and the power distribution on sub-carriers of the frequency domain signal (311).

## Description

### Technical field

The present invention generally relates to communication systems, and more particularly to an automatic gain control method and apparatus for Orthogonal Frequency Division Multiplexing systems.

### Background

Orthogonal Frequency Division Multiplex (OFDM) techniques have been proposed for use in satellite broadcasting systems and other wireless networks. In an OFDM communication system, the digital signal is modulated on a plurality of sub-carrier frequencies that are then transmitted in parallel. OFDM systems have the advantage of easy channel equalization and efficient bandwidth usage. Recent examples of OFDM systems are the 3G Long Term Evolution (LTE) and WiMAX.

Common to most communication systems, and in particular mobile, battery-powered ones, is the aim for low-power, low-complex solutions. This makes it necessary to look at all steps in the signal path and dimension them properly. Designing the system efficiently means in many cases that when using fix-point arithmetic, the signal dynamic range should occupy a suitable portion of the signal range that it used in the hardware and software. Having a too strong signal compared to the design will imply a risk of overflow or other non-linearities. On the other hand, a too low signal span will be affected by e.g., quantization noise when only a few of the Analog-to-Digital Converter (ADC) bits are used.

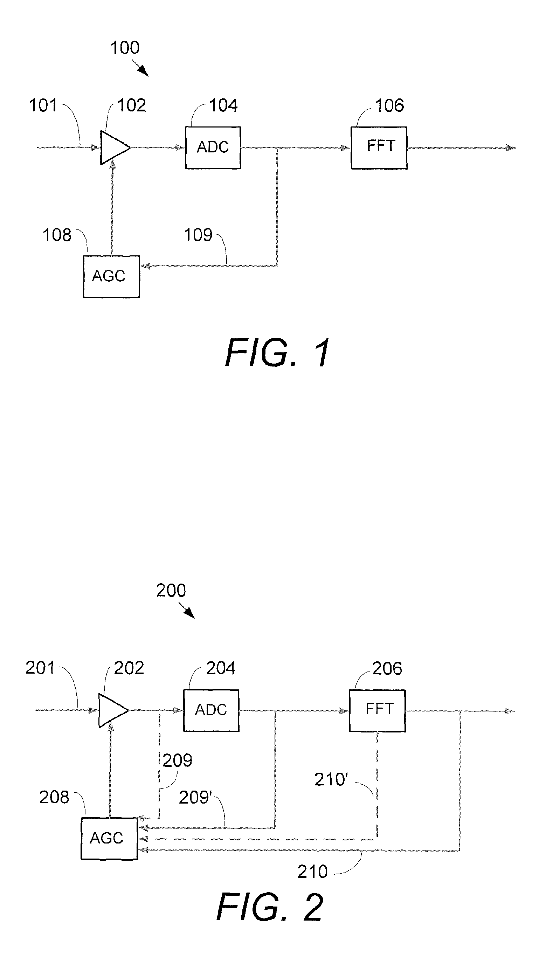

An electronic device 100 for a known OFDM receiver is illustrated in Figure 1. The blocks of the device 100 is comprised of an amplifier 102, an analog to digital converter (ADC) 104, an FFT (Fast Fourier Transform) 106, and an automatic gain control unit (AGC) 108. The amplifier 102 amplifies a received analog signal 101. The amplified analog signal is then converted into a digital signal by the ADC 104. The FFT 106 converts the digital signal from the time domain to the frequency domain. The AGC 108 controls the amplification used by the amplifier 102 based on analyzing a time domain input signal 109, which is obtained prior to the FFT 106.

As mentioned above, the baseband analog signal is sampled by the ADC 104. Since the transmission channel attenuates the signal differently depending on, e.g., distance from the base station, the received power will differ. To match the signal dynamics to the fixed-point dynamic range in the digital signal path, the signal amplitude is normalized by the AGC 108. This will adjust the amplitude level prior to the quantization. As a result, the effects of quantization noise in the ADC 104 are minimized.

To alleviate the problems of a signal with too much variation, the AGC 108 takes as an input the time-domain signal 109. After estimating the power in this signal, the AGC 108 chooses a suitable amplification level for the amplifier to apply to the received signal prior to the ADC 104.

With a multi-carrier system such as OFDM, there is a possibility to transmit data only on selected sub-carriers, while keeping silent on the others. If a narrow frequency band is used, with only a small part of the sub-carriers used in the transmission, the power in the time domain signal might be low although the power on selected sub-carriers is high.

Based on the low average power of the time signal, the AGC 108 will interpret the signal as weak and give a high gain. However, after transformation of the signal by the Fast Fourier Transform in the FFT 106, all power is assigned to the small band of sub-carriers. Due to the amplification, overflow in the FFT 106 or in the subsequent signal path is now more likely. The same thing can happen after receiver impairments leading to, e.g., a strong DC offset. Due to overflow in the FFT 106 this may affect other sub-carriers.

### Summary

It is the object to provide an automatic gain control method for use in an electronic device for an OFDM receiver, which at least limits the risk of overflow in the frequency domain.

Instead of only using the time-domain signal as an input to the AGC, some embodiments of the invention also uses a frequency domain signal as an input to the AGC, thereby looking at sub-carriers corresponding to the current user and other users as well.

According to some embodiment of the invention, a method for adjusting the gain of an amplifier in a communication receiver is disclosed. The method comprises the steps of estimating the power of a time domain signal; estimating the power distribution on one or more sub-carriers of a frequency domain signal transformed from the time domain signal; and generating a gain control signal for the amplifier based on the estimated power of the time domain signal and the power distribution on sub-carriers of the frequency domain signal.

According to other embodiments, a device automatic gain control for an OFDM receiver is disclosed. The device may comprise an amplifier for amplifying an input signal using a gain control signal; an FFT for converting the time domain signal to a frequency domain signal; and an automatic gain control unit. The automatic gain control unit is adapted to: estimate the power of the time domain signal; estimate the power distribution on one or more sub-carriers of the frequency domain signal; and generate the gain control signal for the amplifier based on the estimated power of the time domain signal and the power distribution on sub-carriers of the frequency domain signal.

Moreover, the device described above may be part of a mobile radio communication device.

According to some embodiments, a computer program comprising program instructions for causing a computer to perform a process comprising: estimating the power of a time domain signal; estimating the power distribution on sub-carriers of a frequency domain signal transformed from the time domain signal; and generating a gain control signal for an amplifier based on the estimated power of the time domain signal and the power distribution on sub-carriers of the frequency domain signal, when said program is run on a computer.

Further embodiments of the invention are defined in the dependent claims.

It should be emphasized that the term "comprises/comprising" when used in this specification is taken to specify the presence of stated features, integers, steps or components but does not preclude the presence or addition of one or more other features, integers, steps, components or groups thereof.

### Brief description of the drawings

Further objects, features and advantages of embodiments of the invention will appear from the following detailed description, reference being made to the accompanying drawings, in which:
Fig. 1 illustrates an electronic device of a known OFDM receiver;
Fig. 2 illustrates an embodiment of an electronic device of an OFDM receiver;
Fig. 3 is a flow chart illustrating a method for adjusting the gain according to one embodiment;
Fig. 4 is a set of signal graphs illustrating the operation of the electronic device according to one embodiment;
Fig. 5 is a set of signal graphs illustrating the operation of the electronic device according to one embodiment; and
Fig. 6 is a set of signal graphs illustrating the operation of the electronic device according to one embodiment.

### Detailed description

Embodiments of the invention provide a method and an electronic device for adjusting the gain of an amplifier in an OFDM receiver using both time domain signals and frequency domain signals as input signals.

A basic block diagram of one embodiment of a device 200 for automatic gain control for an OFDM receiver is illustrated in Figure 2. The device 200 is comprised of an amplifier 202, an analog to digital converter (ADC) 204, an FFT (Fast Fourier Transform) 206, and an automatic gain control unit (AGC) 208. The amplifier 202 amplifies a received analog signal 201. The amplified analog signal is converted into a digital signal by the ADC 204. The FFT 206 converts the digital signal from the time domain to the frequency domain. The AGC 208 is adapted to control the amplification used by the amplifier 202 based on a time domain signal and a frequency domain signal.

The AGC 208 has multiple inputs in order to work in narrow-band and wide band scenarios. The time domain signal can be acquired before the ADC 204, which is denoted by the broken line 209, or between the ADC 204 and the FFT 206, which is denoted by the unbroken line 209', as shown in the embodiment of Figure 2. The frequency domain signal can be acquired from the FFT 206 as a completed FFT signal, denoted by the unbroken line 210, or before the final output of the FFT 206 as an intermediate FFT signal, as denoted by the broken line 210'.

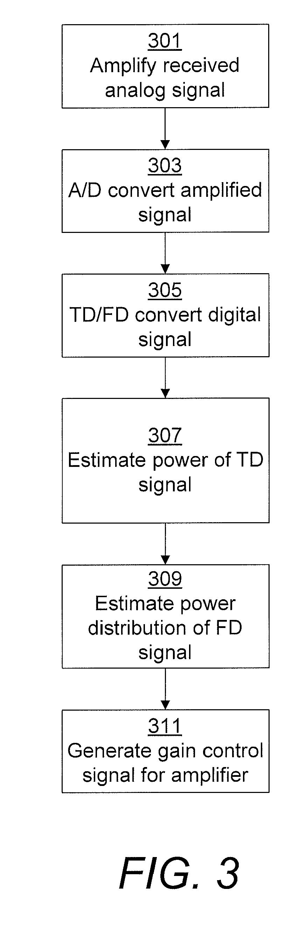

The operation of the device 200 will now be described with reference to Figure 3. In step 301, a received analog signal 201 is amplified in the amplifier 202 using a selected amplification value. The amplified analog signal, i.e the analog time domain signal 209, is then converted to a digital signal, i.e the digital time domain signal 209', by the analog-to-digital converter 204 in step 303. The digital signal, in step 305, is then converted from the time domain (TD) signal to a frequency domain (FD) signal by the FFT 206. The time domain signal and the frequency domain signal are received as input signals in the AGC 208. The power of the time domain signal derived from an input signal is estimated in step 307 and the power distribution on one or more sub-carriers of the frequency domain signal is estimated in step 309. Although, the estimation of the power of the time domain signal and the power distribution on one or more sub-carriers of the frequency domain signal is described as two separated steps in a particular order in this embodiment, the method is not intended to be a limiting feature. The estimations of power of the time domain signal and the distribution on one or more sub-carriers of the frequency domain signal may be performed in a different order or in parallel by the AGC 208.

The AGC 208 then generates a gain control signal for the amplifier based on the estimated power of the time domain signal and the power distribution on sub-carriers of the frequency domain signal in step 311.

According one embodiment, the AGC 208 may generate the gain control signal by calculating a first amplification value based on the estimated power of the time domain signal and a second amplification value based on the power distribution on sub-carries of the frequency domain signal in steps 307 and 309, respectively. The AGC 208 then selects one of the calculated amplitude values for use by the amplifier in step 311. According to one embodiment of the invention, the AGC 208 selects the lowest of the first and second amplification values to be used in the amplifier. According to another embodiment of the invention, the AGC selects the highest amplification power as long as it is below a predetermined threshold value.

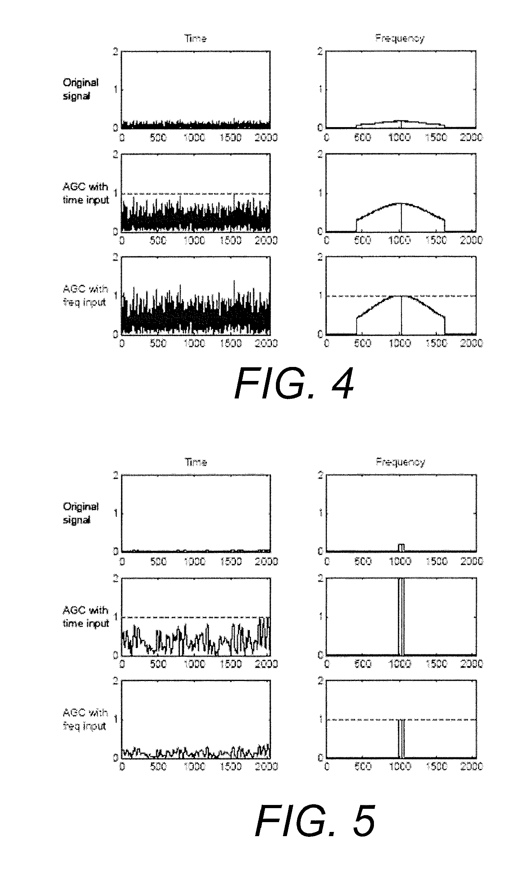

Illustrative examples of the operation of the present invention will now be described with reference to Figures 4-6. The numbers used in the examples are only to show the concept of the invention and the invention is applicable for other choices as well and the invention is not limited thereto.

In the first illustrative example, consider a receiver with Long Term Evolution (LTE) - like parameters with a sampling frequency of 30.72 MHz that can receive a signal with a maximum 20 MHz bandwidth. First consider the case with a wide-band signal, 1201 sub-carriers with 15kHz spacing, as illustrated in Figure 4. The first row shows the original signal in time and frequency domains. The second row shows the signal after a time domain signal as an input to the AGC and the third row shows the signal after a frequency domain signal as an input to the AGC. To simplify the presentations, the time domain signal as an input to the AGC adjusts the signal level so that the maximum time sample matches the dotted line, normalized to the level 1. The frequency domain signal as an input to the AGC adjusts the signal level so that the maximum frequency level matches the dotted line in the frequency plane. Since the signal occupies a large part of the band, the power estimated from the time domain signal has a good relationship to the power at individual sub-carriers. When having both time and frequency domain inputs, the choice should be the lower amplification level, here chosen by the frequency domain signal as an input to the AGC.

With a narrow-band signal as shown in Figure 5, the time-domain signal in the upper row is very weak, and thus the AGC 208 with a time domain input assigns a high amplification. Then, the signal after the OFDM demodulation might end up with too high values on individual sub-carriers, as shown in the center-right plot. A better choice would be to let the AGC 208 operate on the frequency-domain signal as shown in the bottom plots in Figure 5.

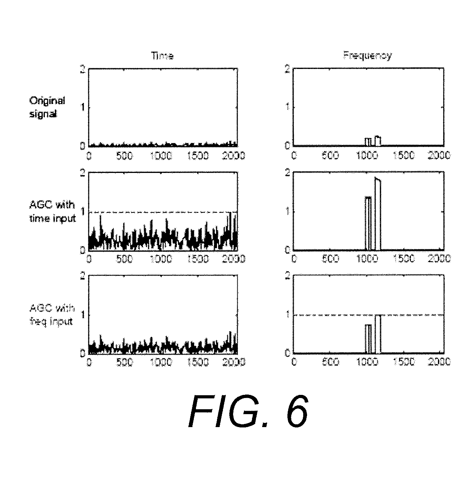

The third example illustrated in Figure 6 shows the same situation as the previous one, now with transmission to another user on a higher frequency, illustrated by the right bar. The time domain signal now has higher amplitude, leading to a gain decrease from the AGC with a time domain signal input. The AGC with a frequency domain signal input, looking at frequencies outside the current user's band, will notice the new transmission and decrease the gain.

Another operation scenario is when the receiver impairments generate a high DC offset before the FFT. If the dynamic range is wide enough, this will only affect the DC sub-carrier, which often is not used for data transmission. However, having overflow in the FFT, the information can leak to other sub-carriers. To handle this scenario, the AGC can measure the DC output of the FFT, and do not need to measure the whole band, to save complexity.

If the users are assigned certain blocks of sub-carriers (resource blocks), complexity can be lowered by not viewing all individual sub-carriers within the resource block, but only one or a few.

The intermediate results inside the FFT can also be used to distinguish if there is a too high value at DC or some other point. Looking inside the FFT may give faster results, and that overflow may occur inside the FFT while not being visible on the outside.

It is of interest to still use the time domain input to the AGC 208, although the frequency domain input now is added. Using the time domain signal can be done with low complexity, and can give a faster result due to the delay in the FFT 206. To handle different Peak to Average Ratio (PAR) levels in the signals, a time domain input is suitable. The high PAR level, that may saturate the ADC, is not visible in the frequency domain.

The signal path in the frequency domain, such as FFT, channel estimation, etc., can be more efficiently dimensioned when applying the invention. This will lead to a lower risk of overflow, or a less complex solution, due to that a smaller signal overhead now is needed. Compared to existing solutions, the invention does not only use pilot tones in the frequency domain, but possibly all sub-carriers that belong to the current user or other users in the same OFDM frame. This solution handles the multi-user case better, where different users each have a smaller frequency range within the OFDM frame.

A portable or handheld mobile radio communication equipment or device, a mobile radio terminal, a mobile telephone, a pager, a communicator, an electronic organizer, or a smartphone may comprise the device 200.

At least some parts of the method, as for example the functionality of AGC 208 and the method steps performed by the same may be embedded in a computer program product, which enables implementation of the method steps and function described herein. The invention may be carried out when the computer program is loaded and run in an apparatus having computer capabilities. Computer program, software program, program product, or software, in the present context mean any expression, in any programming language, code or notation, of a set of instructions intended to cause an apparatus having a processing capability to perform a particular function directly or after conversion to another language, code or notation. The invention also extends to programs on or in a carrier, adapted for putting the invention into practice. The program may be in the form of source code, object code a code suitable for use in the implementation of the method according to the invention. The carrier can be any entity or device capable of carrying the program. For example the carrier may be a record medium, computer memory, read-only memory or an electrical carrier signal.

The present invention has been described above with reference to specific embodiments. However, other embodiments than the above described are possible within the scope of the invention. Different method steps than those described above, performing the method by hardware or software, may be provided within the scope of the invention. The different features and steps of the invention may be combined in other combinations than those described. The scope of the invention is only limited by the appended patent claims.

## Claims

1. A method for adjusting the gain of an amplifier in a communication receiver, comprising:
estimating the power of a time domain signal (307);
estimating the power distribution on one or more sub-carriers of a frequency domain signal (309) transformed from the time domain signal; and
generating a gain control signal for the amplifier based on the estimated power of the time domain signal and the power distribution on sub-carriers of the frequency domain signal (311).

2. The method according to claim 1, wherein the time domain signal is an analog time domain signal.

3. The method according to claim 1, wherein the time domain signal is an analog to digital converted time domain signal.

4. The method according to any of the preceding claims, wherein the frequency domain signal is a completed fast Fourier transformed signal.

5. The method according to any of the claims 1-3, wherein the frequency domain signal is a signal obtained during the generation of the fast Fourier transformed signal as an intermediate result.

6. The method according to any of the preceding claims, wherein the step of generating a gain control signal for the amplifier comprises:
calculating a first amplification value based on the estimated power of the time domain signal and a second amplification value based on the power distribution on sub-carriers of the frequency domain signal.

7. The method according to claim 6, wherein the step of generating a gain control signal for the amplifier comprises:
selecting the lowest of the first and second amplification values as the gain control signal for the amplifier.

8. The method according to claim 6, wherein the step of generating a gain control signal for the amplifier comprises:
selecting the highest amplification value below a predetermined threshold as the gain control signal for the amplifier.

9. The method according to any of the preceding claims, wherein the step of estimating the power distribution on one or more sub-carriers of the frequency domain signal (309), comprises estimating only the power on the DC sub-carrier of the frequency domain signal.

10. A device for automatic gain control for an OFDM receiver, comprising:
an amplifier (202) for amplifying a time domain signal using a gain control signal;
an FFT (206) for converting the time domain signal to a frequency domain signal (210;210'); and
an automatic gain control unit (208) adapted to:
estimate the power of the time domain signal (209;209');
estimate the power distribution on one or more sub-carriers of the frequency domain signal (210;210'); and
generate the gain control signal for the amplifier based on the estimated power of the time domain signal (209;209') and the power distribution on sub-carriers of the frequency domain signal (210;210').

11. The device according to claim 10, wherein the time domain signal is an analog time domain signal (209).

12. The device according to claim 10, wherein the time domain signal is an analog-to-digital converter time domain signal (209').

13. The device according to any of the claims 10-12, wherein the frequency domain signal is an intermediate FFT signal generated by the FFT (210').

14. The device according to any of the claims 10-12, wherein the frequency domain signal is a completed FFT signal generated by the FFT (210).

15. The device according to any of the claims 10-12, wherein the automatic gain control unit (208) is adapted to calculate a first amplification value based on the estimated power of the time domain signal (209;209') and a second amplification value based on the power distribution on sub-carries of the frequency domain signal (210;210').

16. The device according to claim 15, wherein the gain control unit (208) is adapted to select the lowest of the first and second amplification values for the gain control signal for the amplifier (202).

17. The device according to any of the claim15, wherein the automatic gain control unit (208) is adapted to select the highest amplification value below a predetermined threshold for the gain control signal for the amplifier (202).

18. The device according to any of the claims 10-17, wherein the gain control unit (208) is adapted to estimate only the power on the DC sub-carrierof the frequency domain signal (210;210').

19. A mobile radio communication device comprising a device for automatic gain control for an OFDM receiver (200) according to any of the claims 10-18.

20. A mobile radio communication device according to claim 19, wherein the device is a portable or handheld mobile radio communication equipment, a mobile radio terminal, a mobile telephone, a pager, a communicator, an electronic organizer, or a smartphone.

21. A computer program comprising program instructions for causing a computer (100) to perform the process of:
estimating the power of a time domain signal;
estimating the power distribution on sub-carriers of a frequency domain signal transformed from the time domain signal; and
generating a gain control signal for an amplifier based on the estimated power of the time domain signal and the power distribution on sub-carriers of the frequency domain signal,
when said program is run on a computer.

22. A computer program according to claim 21, embodied on a record medium, stored in a computer memory, embodied on a read-only memory, or carried on an electrical carrier signal.

23. A computer program product comprising a computer readable medium, having thereon: computer program code means, when said program is loaded, to make the computer execute the process of:
estimating the power of a time domain signal;
estimating the power distribution on sub-carriers of a frequency domain signal transformed from the time domain signal; and
generating a gain control signal for an amplifier based on the estimated power of the time domain signal and the power distribution on sub-carriers of the frequency domain signal.
